Europäisches Patentamt

European Patent Office

Office européen des brevets

(19)

(11) Veröffentlichungsnummer: **0 190 605**
**A2**

(12) **EUROPÄISCHE PATENTANMELDUNG**

(21) Anmeldenummer: **86100782.1**

(22) Anmeldetag: **22.01.86**

(51) Int. Cl.⁴: **H 01 L 21/225**

(30) Priorität: **31.01.85 DE 3503264**

(43) Veröffentlichungstag der Anmeldung:
**13.08.86 Patentblatt 86/33**

(84) Benannte Vertragsstaaten:
**AT BE CH DE FR GB IT LI LU NL SE**

(71) Anmelder: **Max-Planck-Gesellschaft zur Förderung der Wissenschaften e.V.**
**Bunsenstrasse 10**
**D-3400 Göttingen(DE)**

(72) Erfinder: **Weppner, Werner, Dr.**
**Weinbergstrasse 20a**
**D-7000 Stuttgart 80(DE)**

(74) Vertreter: **Weickmann, Heinrich, Dipl.-Ing. et al,**
**Patentanwälte Dipl.-Ing. H.Weickmann Dipl.-Phys.Dr. K.Fincke Dipl.-Ing. F.A.Weickmann Dipl.-Chem. B. Huber Dr.-Ing. H. Liska Dipl.-Phys.Dr. J. Prechtel Möhlstrasse 22 D-8000 München 80(DE)**

(54) Verfahren zur Änderung der lokalen, atomaren Zusammensetzung von Festkörpern, insbesondere Halbleitern.

(57) Ein Verfahren zur Änderung der lokalen, atomaren Zusammensetzung eines Festkörpers, insbesondere eines Halbleiters, besteht darin, daß man eine Gleichspannung im Volt-Bereich an den Festkörper anlegt unter Bedingungen, unter welchen ein Teil der Festkörperbestandteile in Festkörper in Richtung zu einer der beiden die Spannung erzeugenden Elektroden wandert. Ein Beispiel hierfür ist die Wanderung von Sauerstoff in einer Titan-Dioxyd-Einkristall-Probe.

FIG.1

EP 0 190 605 A2

PATENTANWÄLTE DIPL.-ING. H. WEICKMANN, DIPL.-PHYS. DR. K. FINCKE
DIPL.-ING. F. A. WEICKMANN, DIPL.-CHEM. B. HUBER
DR.-ING. H. LISKA, DIPL.-PHYS. DR. J. PRECHTEL

8000 MÜNCHEN 86
POSTFACH 860 820
MÜHLSTRASSE 22
TELEFON (089) 98 03 52
TELEX 5 22 621
TELEGRAMM PATENTWEICKMANN MÜNCHEN

PREwe

Max-Planck-Gesellschaft
zur Förderung der Wissenschaften e.V.
Bunsenstraße 10

3400 Göttingen

GI 896

## Verfahren zur Änderung der lokalen, atomaren Zusammensetzung von Festkörpern, insbesondere Halbleitern

Die Erfindung betrifft ein Verfahren zur Änderung der lokalen, atomaren Zusammensetzung von Festkörpern, insbesondere dotierten Element-Halbleitern oder ggf. dotierten Verbindungs-Halbleitern.

Bei herkömmlichen Verfahren wird eine abgeänderte lokale Zusammensetzung , insbesondere Dotierung, dadurch erzielt, daß man diese Dotierstoffe in den Festkörper eindiffundieren läßt oder bei der Kristallzucht des Festkörpers schichtweise einwachsen läßt (epitaktische Verfahren). Auch ist es bekannt, den zu dotierenden Festkörper mit den Dotierungsstoffen zu beschießen (Ionen-Implantation). Diese bekannten Verfahren sind aufwendig.

Die Aufgabe der Erfindung liegt demgegenüber darin, ein Verfahren gattungsgemäßer Art zu vereinfachen.

Diese Aufgabe wird durch die kennzeichnenden Merkmale des Anspruchs 1 in Verbindung mit den Merkmalen des Oberbegriffs gelöst.

Üblicherweise wird beim Anlegen einer Spannung am Halbleiter lediglich eine Bewegung elektronischer Ladungsträger (Elektronen bzw. Löcher) erwartet. Unerwartetermaßen bewegen sich unter Umständen aber auch die atomaren Komponenten des Festkörpers. Die an den Festkörper, insbesondere Halbleiter, angelegte äußere Spannung erzeugt ein inneres elektrisches Feld, das eine treibende Kraft für die Verschiebung der Ionen des Kristallgitters bzw. von Ionen auf Zwischengitterplätzen darstellt. Hinzu kommt, daß es im jeweiligen Elektroden-Bereich rasch zu einer Anreicherung bzw. Verarmung an wandernden Stoffen und somit zu Konzentrationsgradienten kommt, die eine Diffusion von Teilchen aus dem Bulk-Bereich veranlassen, bis eine angenäherte Gleichverteilung erreicht ist. Wird im folgenden vom "elektrochemischen Potentialgradienten" gesprochen, so soll darunter das vom elektrischen Feld sowie den Konzentrationsgradienten herrührende, auf die einzelnen Teile einwirkende Kraftfeld verstanden werden. Die lokale Verschiebung erfolgt unerwartetermaßen schnell. Es läßt sich eine Beweglichkeit atomarer Teilchen beobachten, die in der gleichen Größenordnung liegt, wie bei Flüssigkeiten und in einigen Fällen sogar wie bei Gasen. Im Falle von Halbleitern ergeben sich aufgrund der bereitwilligen Ladungsabgabe (bei Donatoren) bzw. Ladungsübernahme (bei Akzeptoren) von atomaren Komponenten des Halbleiters eine entsprechende Ionen-Ladung dieser Komponenten; das elektrische Feld am Ionen-Ort übt dann eine entsprechende Verlagerungs-Kraft auf die Ionen aus. Das hierfür maßgebliche lokale elektrische Feld kann unter Umständen größer sein, als das äußere elektrische Feld, insbesondere aufgrund von lokalen Feldern, die von den sehr beweglichen Elektronen bzw. Löchern im Halbleiter erzeugt werden. Abhängig von der Art des Festkörpers und ggf. der Art der Dotierungs-Atome werden die äußeren Bedingungen, wie Spannungshöhe und Temperatur, festgelegt. Bei manchen Dotierungsstoffen muß der Festkörper stärker erhitzt werden (bis etwa max. 10 % unterhalb der Schmelztemperatur (Kelvin-°). Bei den Stoffen gemäß Anspruch 2 dagegen beobachtet man die gewünschte Wanderung bereits bei Raumbedingungen (Raumtemperatur und Atmosphärendruck).

Von besonders hoher Beweglichkeit ist Sauerstoff gemäß Anspruch 3, in einem Verbindungs-Halbleiter am besten in Titan-Dioxyd.

In den Ansprüchen 4 bis 9 sind weitere wandernde Stoffe angegeben sowie sich besonders eignende Halbleiter. Bei den aufgeführten Verbindungs-Halbleitern sind es die Verbindungskomponenten selbst, die wandern.

Im allgemeinen ist der beobachtbare Wanderungs-Effekt mehr oder minder reversibel, d.h. nach Abklemmung der die Gleichspannung erzeugenden Spannungsquelle erfolgt eine Rückwanderung der wandernden Stoffe, vor allem aufgrund des Bestrebens, eine Gleichverteilung der Stoffe im Festkörper zu erhalten. In denjenigen Fällen, in denen diese Rückwanderung unerwünscht ist, friert man die geänderte lokale, atomare Zusammensetzung gemäß Anspruch 11 ein.

Die Erfindung betrifft ferner ein Herstellungsverfahren für einen Halbleiter mit lokal unterschiedlichen elektrischen Eigenschaften durch Anwendung des vorstehend genannten Verfahrens, wobei im Falle wandernder Dotierstoffe Akzeptoren und/oder Donatoren als Dotierstoffe eingesetzt werden. Da Halbleiter nur eine relativ geringe Zahl von Ladungsträgern (Elektronen bzw. Löcher) aufweisen und deren Zahl im wesentlichen der entsprechenden Zahl von Donatoren bzw. Akzeptoren entspricht, ergeben sich bereits bei relativ geringen Konzentrationsänderungen der Akzeptoren bzw. Donatoren erhebliche Änderungen der Leitungseigenschaften in diesem Bereich.

In den Ansprüchen 13 bis 15 sind drei bevorzugte Verfahrensweisen zur Herstellung eines p-n-Übergangs in einem Halbleiter angegeben, für den Fall, daß lediglich die Akzeptoren bzw. Donatoren wandern können (Anspruch 13), für den Fall, daß sowohl Akzeptoren und Donatoren wandern (Anspruch 14) sowie schließlich für den Fall eines Verbindungshalbleiters mit wandernden positiven und negativen Verbindungskomponenten (Anspruch 15). Die jeweilige Anfangszusammensetzung bzw. Anfangs-Dotierung des Halbleiters (homogen über das Halbleiter-Volumen) ist also derart festgelegt, daß sich nach der spannungsbedingten Wanderung der betreffenden Bestandteile zwei Bereiche mit n-Leitung bzw. p-Leitung ergeben.

Das Verfahren nach Anspruch 12 läßt sich also ohne weiteres zur Herstellung von Bipolartransistoren mit p-n-Übergang einsetzen wie auch von Unipolartransistoren.

Gemäß Anspruch 16 läßt sich die Umpolung eines p-n-Übergangs erreichen.

Die Erfindung betrifft auch Halbleiter-Bauelemente gemäß den Ansprüchen 17 und 18.

Wenn man an diejenigen Elektroden des Halbleiter-Bauelements, die unter Spannung gesetzt die gewünschte Wanderung der Donatoren bzw. Akzeptoren bewirken, eine zu beeinflussende Spannung anlegt, und das Halbleiter-Bauelement unter solchen Bedingungen betreibt, unter welchen die Wanderung weiterhin möglich ist, so ergibt sich eine von der jeweils angelegten Spannung abhängige unterschiedliche Raumverteilung der Ladungsträger und damit ein unterschiedlicher Widerstand des Bauelements zwischen den Elektroden. Dieser Widerstand wird bei einem auf diese Weise gebildeten p-n-Übergang im allgemeinen mit wachsender Spannung abnehmen.

Friert man die Akzeptoren- und Donatoren-Raumverteilung nach deren Erzeugung im elektrischen Feld ein, so läßt sich das erhaltene Halbleiter-Bauelement auch als Diode, insbesondere Gleichrichter-Diode einsetzen. Unter Umständen ist auch ein Betrieb bei weiterhin möglicher Teilchen-Wanderung durchführbar, dann nämlich, wenn nur kurzzeitige Spannungsumpolungen stattfinden. Kurzzeitig bedeutet hier im Vergleich zur Trägheit des Wander-Effekts. Man kann davon ausgehen, daß sich bei Anlegen einer Spannung die p-n-Bereiche mit einer im Sekundenbereich liegenden Verzögerung ausbilden. Demgegenüber schnellere Spannungsumpolungen verändern die Polung nicht und werden daher bei normalerweise in Durchlaßrichtung geschalteter Diode nicht durchgelassen.

Es lassen sich ohne weiteres auch mehrere p-n-Übergänge herstellen, wozu man entweder in mehreren aufeinanderfolgenden Schritten eine entsprechende spannungsbedingte Dotierstoff-Wanderung erzeugt oder indem man den Halbleiter mit einer entsprechenden Elektroden-Anordnung versieht, daß sich die gewünschte Dotierungs-Verteilung ergibt. Das erhaltene Halbleiter-Bauelement läßt sich gemäß Anspruch 21 als Steuerelement einsetzen.

Die Erfindung betrifft auch ein Verfahren zur Anreicherung von Stoffen gemäß Anspruch 22. Hierbei wird ausgenützt, daß erfindungsgemäß eine selektive Wanderung von Stoffen in Richtung zur jeweiligen Elektrode induziert wird. Der gewünschte Stoff reichert sich dann an der entsprechenden Elektrode an und kann nach Bedarf dadurch gewonnen werden, daß man diesen Bereich des Festkörpers abtrennt und weiterverarbeitet. Gemäß Anspruch 23 kann man jedoch

0190605

auch die entsprechende, am Festkörper vorgesehene Elektrode für den jeweiligen Stoff durchlässig ausbilden, so daß dieser aus dem Festkörper entweichen kann. Im Falle von wandernden Stoffen, die als Gase beständig sind, wird dann das Gas durch diese poröse Elektrode abgegeben. Bei anzureichernden Stoffen, welche im Bereich der jeweiligen Elektrode kondensieren, geht man bevorzugt gemäß Anspruch 24 vor, um die Abgabe des Stoffes zu beschleunigen.

Das eben beschriebene Verfahren läßt sich auch zur Isotopen-Trennung einsetzen, da die Wanderung der Stoffe in dem von der angelegten äußeren Spannung verursachten elektrochemischen Potentialgradienten innerhalb des Festkörpers auch von den Diffusionseigenschaften der Stoffe abhängig ist.

Das erfindungsgemäße Verfahren läßt sich auch zur Gewinnung von Einzelbestandteilen aus einem Fluid gemäß Anspruch 26 einsetzen.

In gewissem Ausmaße ist auch der Vorgang der Abgabe eines im Festkörper wandernden Stoffes durch die entsprechende Elektrode bei unter Spannung stehendem Festkörper reversibel. Dies kann man gemäß Anspruch 26 zur Gewinnung von Einzelbestandteilen aus einem Fluid nutzen. Der nicht unter Spannung stehende Festkörper nimmt bevorzugt diejenigen Komponenten aus dem mit ihm in Kontakt stehenden Fluid auf, die im Festkörper wandern können. Legt man dann an den Festkörper Spannung an, so werden die eindiffundierten Stoffe zur entsprechenden Elektrode bewegt und von dieser abgegeben.

Gemäß Anspruch 27 läßt sich das eben genannte Verfahren in einem Gasspeicher anwenden.

Die Erfindung wird im folgenden an Hand der Zeichnung an mehreren bevorzugten Ausführungsbeispielen erläutert. Es zeigt:

Fig. 1 einen schematischen Versuchsaufbau;

Fig. 2 eine mit dem Versuchsaufbau gemäß Fig. 1 erhältliche Meßkurve;

Fig. 3 und 4 eine schematische Ansicht eines $TiO_2$-Kristalls vor bzw. nach dem Anlegen einer elektrischen Spannung;

Fig. 5 und 6 Ansichten entsprechend den Figuren 3 und 4 bei einem $Cu_2O$-Kristall;

Fig. 7 und 8 Ansichten entsprechend den Figuren 3 und 4 bei einem In Sb-Kristall und

Fig. 9 und 10 Ansichten entsprechend den Figuren 3 und 4 bei einem Si-Kristall.

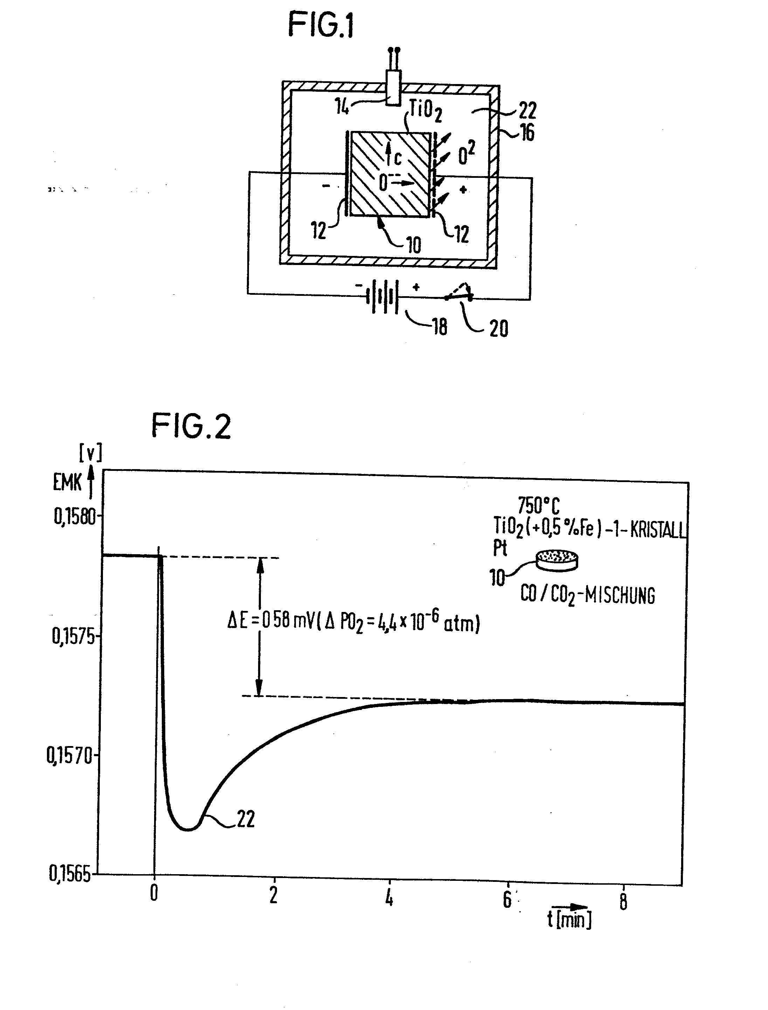

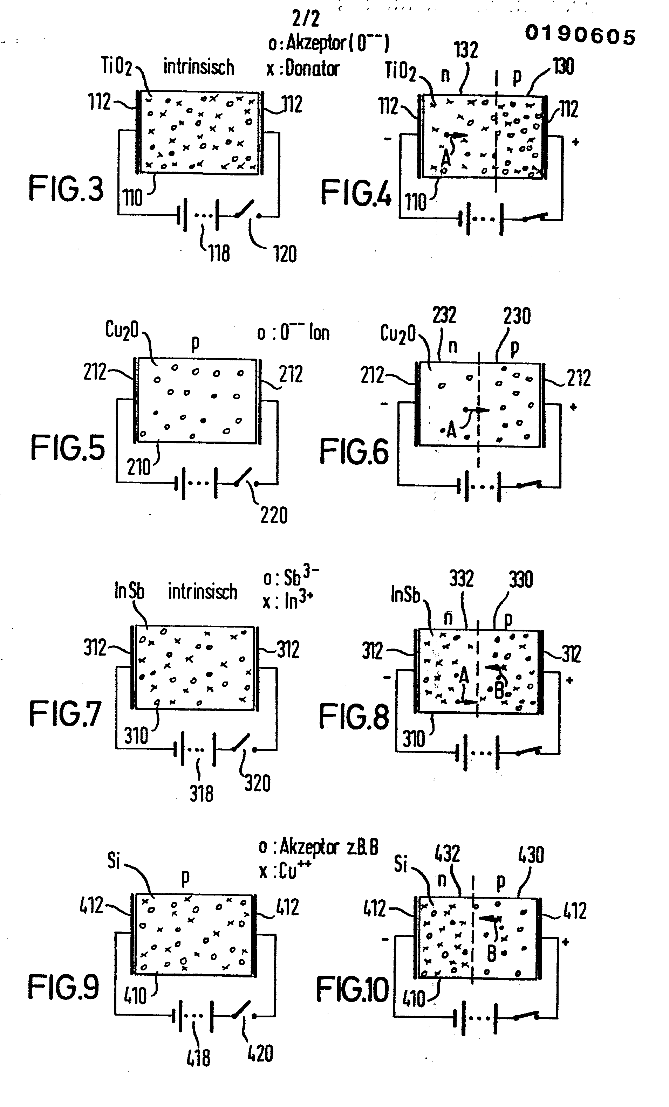

Eine $TiO_2$-Kristallprobe 10 wurde gemäß Fig. 1 mit Platin-Elektroden 12 an den Stirnflächen der Scheibenform versehen, wobei zumindest die positive Elektrode (Anode) porös ausgebildet ist. Die Dicke der Probenscheibe betrug 0,21 cm und deren Durchmesser 1 cm. Die Probe war mit 0,5 % Fe versehen. Die Probe 10 war in unmittelbarer Nachbarschaft (Abstand etwa 2 mm) neben einer Sauerstoffsonde 14 (platiniertes, geschlossenes

$ZrO_2$-Rohr) angeordnet. Eine $H_2/CO_2$-Mischung wurde in ein in Fig. 1 angedeutetes, die Probe 10 einschließendes Versuchsgehäuse 16 mit definiertem Sauerstoff-Partialdruck eingeleitet. Das Gehäuse war gasdicht abgeschlossen. Das Gasvolumen betrug ca. 200 $cm^3$. Die Probentemperatur betrug 750° C.

Die Fig. 2 gibt die von der Sauerstoffsonde 14 abgegebene, zum jeweiligen Sauerstoff-Partialdruck innerhalb des Gehäuses 16 umgekehrt proportionale EMK an. Mit Hilfe der in Fig. 1 angedeuteten Spannungsquelle 18 sind die beiden Elektroden 12 über einen dazwischengeschalteten Schalter 20 unter Spannung setzbar. Wird nun zum Zeitpunkt t = O der Schalter 20 geschlossen, so baut sich eine Spannung von etwa 1 V zwischen den Elektroden auf. Innerhalb von größenordnungsmäßig 1 bis 3 Sekunden ergibt sich ein Ausschlag der EMK nach unten, der schließlich nach einem Überschwinger 22 in einen neuen tieferen Wert übergeht. Bei einem Sauerstoff-Partialdruck von 1,63 x $10^{-4}$ atm ergibt ein EMK-Abfall von 0,58 mV eine Zunahme des Sauerstoff-Partialdrucks um 4,4 x $10^{-6}$ atm. Der Überschwinger 22 läßt sich als Vorbeiwandern einer von der porösen Elektrode 12 abgegebenen Sauerstoffwolke verstehen, die anschließend sich gleichmäßig über den Innenraum 22 des Gehäuses verteilt.

Unter Annahme eines freigesetzten Sauerstoff-Gasvolumens von 50 $cm^3$ ergibt sich daraus das Freisetzen von 5,9 x $10^{15}$ Teilchen Sauerstoff. Bei einem Molvolumen von 18,7 $cm^3$ und 0,785 $cm^2$ Elektrodenfläche befinden sich 15,8 x $10^{14}$ O-Atome in der Oberflächenschicht. Es wurden daher mengenmäßig 7,4 atomare Sauerstofflagen an die Gasphase abgegeben. Der Versuch läßt sich so interpretieren, daß die Sauerstoff-Ionen ($O^{--}$) in dem vom angelegten elektrischen Feld hervorgerufenen elektrochemischen Potentialgradienten zur Anode wandern und von dieser abgegeben werden.

Nach dem Abschalten der Spannung erniedrigt sich der mittlere Sauerstoff-Partialdruck in der Umgebung der Probe; es wird also wieder Sauerstoff in die Probe 10 eingebaut. Bei einer, auch bei diesem Versuch, bei 750° C liegenden Probentemperatur und einem Anfangs-Sauerstoff-Partialdruck von $1,3 \times 10^{-4}$ atm. ergibt sich nach Abschalten einer angelegten Spannung von 1 V ein Sauerstoff-Partialdruck in der Umgebung der Probe, welcher um rund 5% niedriger ist.Die Trägheit des Sauerstoffeinbaus ist im Vergleich zur sauerstoffbedingten Abgabe mit 20 bis 30 Minuten wesentlich höher.

Dieser Versuch zeigt also, daß das Anlegen niedriger Gleichspannungen (im Volt-Bereich) die Stöchiometrie eines Halbleiters geändert werden kann. Aufgrund der Wanderung ionischer Bestandteile des Festkörpers, können sich lokale Unterschiede in der Zusammensetzung des Festkörpers ergeben und in der Folge unterschiedliche elektronische Leitfähigkeits-Eigenschaften in unterschiedlichen Volumen-Bereichen. Üblicherweise wird beim Anlegen einer Spannung am Halbleiter die Bewegung elektronischer Ladungsträger (Elektronen und Löcher) erwartet. Überraschenderweise bewegen sich jedoch auch atomare Komponenten des Festkörpers. Die an den Halbleiter angelegte äußere Spannung erzeugt einen elektrochemischen Potentialgradienten der eine treibende Kraft für die Verschiebung von Ionen des Kristalls erzeugt. Die lokale Verschiebung erfolgt für einen Festkörper unerwartet schnell. Halbleitermaterialien sind bevorzugt, da hier Stoffe vorhanden sind, die bereitwillig Ladung abgeben (Donatoren) bzw. Ladungen aufnehmen (Akzeptoren), und so als Ionen betrachtet werden können. Auch wirken sich Konzentrationsänderungen der Donatoren bzw. Akzeptoren dramatisch auf die elektrischen Leitfähigkeiten im jeweiligen Bereich aus. Die inneren elektrischen Felder können von den äußeren elektrischen Feldern ggf. beträchtlich abweichen, insbesondere aufgrund einer simultanen Wanderung der sehr beweglichen Elektronen bzw. Löcher. Jedenfalls läßt sich eine Beweglichkeit atomarer Teilchen im Festkörper beobachten, die von der gleichen Größenordnung ist, wie in Flüssigkeiten oder in einigen Fällen sogar wie in Gasen.

Ein erstes Anwendungsbeispiel ist die Herstellung eines p-n-Übergangs in einem $TiO_2$-Einkristall. Gemäß Fig. 3 wird die Probe 110 wiederum mit Elektroden 112 versehen, die im vorliegenden Falle zweckmäßigerweise durchgehend ausgebildet sind, d.h. undurchlässig für Sauerstoff. Die Probe 10 ist geringfügig (im Bereich 1 Mol %) mit $Fe_2O_3$ oder $Ta_2O_5$ dotiert. Diese als Donatoren wirkende Teilchen sind in den Figuren 3 und 4 mit kleinen Kreuzchen symbolisiert. Die mit kleinen Kreisen symbolisierten Akzeptoren werden von den Sauerstoff-Ionen gebildet. Die Probe befindet sich in gewöhnlicher Atmosphärenluft. Bei diesem Sauerstoff-Partialdruck befindet sich die Probe 110 etwa im Bereich ihres intrinsischen Punkts, d.h. die Elektronen-Leitung entspricht größenordnungsmäßig der Löcher-Leitung. Man kann auch einen erhöhten Sauerstoff - Partialdruck von beispielsweise 1 atm anwenden, woraufhin nach Einstellung des Gleichgewichts die Probe 110 aufgrund des Überwiegens der Akzeptoren p-leitend wird.

Die Elektroden 112 sind an eine Spannungsquelle 118 (2 V) über einen Schalter 120 angelegt. Schließt man nun den Schalter, so stellt sich nach kurzer Zeit eine Akzeptoren-Verteilung gemäß Fig. 4 ein. Die in Pfeilrichtung A in Fig. 4 wandernden Akzeptoren sammeln sich im Bereich positiven Elektrode 112. Da die Donatoren im wesentlichen unbeweglich im Gitter sind, verändert sich deren räumliche Verteilung über die Probe 110 allenfalls geringfügig. Man erhält somit

0190605

einen Bereich 130 an der positiven Elektrode 112, in welchem die Akzeptoren-Dichte größer die Donatorendichte ist. Dieser Bereich 130 ist demzufolge p-leitend. Umgekehrt ergibt sich im Bereich der anderen Elektrode 112 ein Bereich 132, in welchem die Donatoren-Dichte die Akzeptoren-Dichte übersteigt. Dieser Bereich 132 ist n-leitend.

In den Figuren 5 und 6 wird die Probe 220 von einem $Cu_2O$-Kristallgebildet. Bei diesem Halbleiter ist normalerweise ein geringer stöchiometrischer Sauerstoff-Überschuß vorhanden; die Probe 220 ist demzufolge p-leitend. Legt man nun durch Schließen des Schalters 220 wiederum ca. 2 V an die Elektroden 212, so ergibt die Wanderung der von den Sauerstoff-Ionen gebildeten, in den Figuren mit kleinen Kreisen symboliesierten Akzeptoren zur positiven Elektrode hin, dort einen p-leitenden Bereich 230 und an der anderen Elektrode einen n-leitenden Bereich 232. Da sowohl in diesem Falle wie auch im Falle des $TiO_2$ eine Erhöhung der Sauerstoff-Konzentration im Bereich der positiven Elektrode gewünscht ist, sieht man davon ab, die positive Elektrode sauerstoffdurchlässig auszubilden.

Die Probe 320 gemäß Figuren 7 und 8 besteht aus einem Verbindungs-Halbleiter, nämlich InSb. Hierbei dient die Verbindungskomponente Sb als in den Figuren mit einem kleinen Kreis angedeuteter Akzeptor und die Verbindungskomponente In als mit einem kleinen Kreuz angedeuteter Donator. Beide Komponenten verschieben sich im elektrischen Feld in entgegengesetzten Richtungen (Pfeile A und B in Fig. 8).

Legt man nun die 2 V- Batterie 318 durch Schließen des Schalters 320 an die bislang intrinsisch leitende Probe 310 an, so ergibt sich wiederum die gewünschte Aufteilung der Probe 320 in einem p-leitenden Bereich 330 nächst der Positiv-Elektrode 312 sowie einen n-leitenden Bereich 332 nächst der negativen Elektrode. Der Bereich 330 hat überwiegende Akzeptoren-Dichte und der Bereich 332 überwiegende Donatoren-Dichte.

Die Probe 410 gemäß Figuren 9 und 10 besteht aus einem Si-Kristall, welcher mit üblichen Akzeptoren (z.B. B) dotiert ist. Als Donator werden $Cu^{++}$-Ionen verwendet, die in den Figuren 9 und 10 wiederum mit einem Kreuzchen symbolisiert sind. Geht man entsprechend den Figuren 5 und 6 wiederum von einer p-leitenden Probe 410 aus, d.h. mit Akzeptoren-Überschuß, so ergibt sich nach Anlegen der Spannungsquelle 418 über den Schalter 420 an die Elektroden 412 eine Wanderung hauptsächlich der Donatoren in Richtung des Pfeils B zur negativen Elektrode 412. Die über den Raum homogene Verteilung der Akzeptoren bleibt im wesentlichen erhalten. Die Anfangsdotierung mit Akzeptoren und Donatoren wurde so festgelegt, daß nun nach Wanderung der Donatoren zur negativen Elektrode der Bereich 432 an dieser Elektrode einen Donatoren-Überschuß aufweist und somit n-leitend ist. Der gegenüberliegende Bereich 430 an der positiven Elektrode ist p-leitend.

Will man die erhaltene Inhomogenität der räumlichen Akzeptoren-Verteilung und Donatoren-Verteilung auch dann aufrechterhalten, wenn keine Spannung an den Elektroden liegt, so muß der Kristall so weit abgekühlt werden, daß die Teilchenwanderung praktisch unterbunden ist. Bei denjenigen Kristallen, bei denen die Teilchenwanderung erst bei Temperaturen weit über Raumtemperatur (z.B. In Sb) stattfindet, genügt es, die Probe auf Raumtemperatur zu bringen.

Durch Umkehrung der angelegten Spannung läßt sich auch der entsprechende n-p-Übergang umpolen.

Die gemäß Figuren 4, 6, 8 und 10 erhaltenen Ladungsverteilungen entsprechen bezüglich der angelegten Spannung einer Schaltung in Durchlaßrichtung. Erhöht man die angelegte Spannung, so vermindert sich der von der jeweiligen Probe gebildete Ohm'sche Widerstand. Man erhält also einen spannungsabhängigen Widerstand.

Friert man die Donatoren- und Akzeptoren-Verteilung ein, so läßt sich die jeweilige Probe als Gleichrichter verwenden, da bezüglich umgepolter Spannungen die Probe Sperrfunktion hat. Bei kurzzeitigen Spannungsumpolungen sollte auch ein Betrieb der Probe bei Temperaturen möglich sein, die die Teilchenwanderung weiterhin zulassen. Die Spannungsumpolung muß nur kurzzeitiger sein, als die für die Umpolung der Probe erforderliche Zeitspanne.

Das erfindungsgemäße Prinzip der Anreicherung von wandernden Komponenten innerhalb eines Festkörpers durch Einwirken eines durch Anlegen einer äußeren Spannung hervorgerufenen elektrochemischen Potientialgradienten läßt sich in vielfältiger Weise auch auf anderen Gebieten, wie dem Gebiet elektrischer Bauelemente, anwenden. Anwendungsbeispiele hierfür sind in den Seiten 5 und 6 angegeben.

PATENTANWÄLTE  DIPL.-ING. H. WEICKMANN, DIPL.-PHYS DR. K. FINCKE
DIPL.-ING. F. A. WEICKMANN, DIPL.-CHEM. B. HUBER
DR.-ING. H. LISKA,  DIPL.-PHYS. DR. J. PRECHTEL

PREwe

8000 MÜNCHEN 86
POSTFACH 860 820
MÜHLSTRASSE 22
TELEFON (0 89) 98 03 52
TELEX 5 22 621
TELEGRAMM PATENTWEICKMANN MÜNCHEN

Max-Planck-Gesellschaft
zur Förderung der Wissenschaften e.V.
Bunsenstraße 10

3400 Göttingen

## Verfahren zur Änderung der lokalen, atomaren Zusammensetzung von Festkörpern, insbesondere Halbleitern

## Patentansprüche

1. Verfahren zur Änderung der lokalen, atomaren Zusammensetzung eines Festkörpers, insbesondere eines ggf. dotierten Element-Halbleiters oder Verbindungs-Halbleiters, dadurch g e k e n n z e i c h n e t , daß man eine Gleichspannung im Voltbereich an den Festkörper anlegt unter Bedingungen, unter welchen ein Teil der Festkörperbestandteile, insbesondere ein Teil der Dotierungs-Atome bzw. wenigstens eine der Verbindungskomponenten im Festkörper in Richtung zu einer der beiden die Spannung erzeugenden Elektroden wandert.

2. Verfahren nach Anspruch 1, dadurch g e k e n n z e i c h n e t , daß man als wandernden Stoff einen unter Raumbedingungen stabilen, gasförmigen Stoff einsetzt.

3. Verfahren nach Anspruch 2,
   dadurch gekennzeichnet ,
   daß man als wandernden Stoff Sauerstoff einsetzt,
   vorzugsweise in Verbindung mit einem Verbindungs-
   Halbleiter, am besten mit Titandioxyd (Rutil), vorzugsweise bei einer Temperatur zwischen Raumtemperatur
   und 1000° C, am besten etwa 750° C.

4. Verfahren nach Anspruch 2,
   dadurch gekennzeichnet ,
   daß man als wandernden Stoff ein Halogen, vorzugsweise Chlor einsetzt, vorzugsweise in $W Cl_6$, vorzugsweise
   bei einer Temperatur zwischen Raumtemperatur und 275° C,
   am besten etwa 150° C.

5. Verfahren nach Anspruch 2,
   dadurch gekennzeichnet ,
   daß man als wandernden Stoff Kupfer einsetzt, vorzugsweise in einem Element-Halbleiter, am besten in
   Silicium, vorzugsweise bei einer Temperatur zwischen
   Raumtemperatur und 1400° C, am besten etwa 300° bis
   400° C.

6. Verfahren nach einem der vorhergehenden Ansprüche,
   dadurch gekennzeichnet ,
   daß man eine sauerstoffhaltige Verbindung einsetzt,
   vorzugsweise Titan-Dioxyd ($Ti O_2$) bei einer Temperatur
   zwischen Raumtemperatur und 1000° C, am besten etwa
   750° C oder $Cu_2O$ bei einer Temperatur vorzugsweise
   zwischen 400° und 800° C, am besten etwa 600° C.

7. Verfahren nach einem der Ansprüche 1 bis 5,
   dadurch gekennzeichnet ,
   daß man einen 3-5-Verbindungshalbleiter einsetzt,
   vorzugsweise In Sb bei einer Temperatur vorzugsweise
   oberhalb 300° C, am besten etwa 400° C.

8. Verfahren nach einem der Ansprüche 1 bis 5,
dadurch g e k e n n z e i c h n e t ,
daß man als Verbindungshalbleiter $Li_3$ Sb oder $Li_3$ Bi
einsetzt bei einer Temperatur vorzugsweise zwischen
Raumtemperatur und 600° C, am besten von etwa 400°C.

9. Verfahren nach einem der Ansprüche 1 bis 8,
dadurch g e k e n n z e i c h n e t ,
daß man Verbindungshalbleiter $Ag_2$ S einsetzt bei
einer Temperatur vorzugsweise zwischen 150° C und 300° C.

10. Verfahren nach einem der vorhergehenden Ansprüche,
dadurch g e k e n n z e i c h n e t ,
daß man zur Förderung der Wanderung den Festkörper
vor oder während dem Anlegen der Spannung erhitzt.

11. Verfahren nach einem der vorhergehenden Ansprüche,
dadurch g e k e n n z e i c h n e t ,
daß man den Festkörper zum Einfrieren der geänderten
lokalen, atomaren Zusammensetzung nach dem Anlegen der
Spannung abkühlt.

12. Herstellungsverfahren für einen Halbleiter mit lokal
unterschiedlichen elektrischen Leitungseigenschaften
durch Anwendung des Verfahrens nach einem der vorhergehenden Ansprüche, wobei im Falle wandernder Dotierstoffe Akzeptoren und/oder Daonatoren als Dotierstoffe
eingesetzt werden.

13. Herstellungsverfahren nach Anspruch 12 zur Herstellung
eines Halbleiters mit wenigstens einem p-n-Übergang,
dadurch g e k e n n z e i c h n e t ,
daß man bei einem Halbleiter mit im elektrochemischen
Potentialgradienten wandernden Akzeptoren, insbesondere
$O^{--}$, oder wandernden Donatoren den Halbleiter vor dem Anlegen der Spannung derart dotiert, daß er sich bezüglich seiner elektrischen Leitfähigkeit im Bereich des intrinsischen Punktes (n-Leitung = p-Leitung) befindet oder geringfügig p-leitend bzw. n-leitend ist, so daß nach dem Anlegen der Spannung der aufgrund der weggewanderten Akzeptoren bzw. Donatoren entsprechend verdünnte Bereich des Halbleiters n-leitend bzw. p-leitend ist (Figuren 3 bis 6, 9 und 10).

14. Herstellungsverfahren nach Anspruch 12 zur Herstellung eines Halbleiters mit wenigstens einem p-n-Übergang, dadurch gekennzeichnet , daß man bei einem Halbleiter mit im elektrochemischen Potentialgradienten wandernden Akzeptoren und Donatoren den Halbleiter derart notiert, daß er sich vor dem Anlegen der Spannung bezüglich seiner elektrischen Leitfähigkeit im Bereich des intrinsischen Punktes (n-Leitung = p-Leitung) befindet (Figuren 7 bis 10).

15. Herstellungsverfahren nach Anspruch 12 zur Herstellung eines Halbleiters mit mindestens einem p-n-Übergang, dadurch gekennzeichnet , daß man bei einem Verbindungshalbleiter mit im elektrochemischen Potentialgradienten wandernden positiven und negativen Verbindungskomponenten den Halbleiter derart zusammensetzt, daß er sich vor dem Anlegen des elektrischen Feldes bezüglich seiner elektrischen Leitfähigkeit im Bereich des intrinsischen Punktes (n-Leitung = p-Leitung) befindet (Figuren 7 und 8).

16. Verfahren zur Umpolung eines p-n-Übergangs eines Halbleiters unter Anwendung des Verfahrens nach einem der Ansprüche 1 bis 11, dadurch gekennzeichnet ,

daß man an den ggf. erhitzten Halbleiter eine Umpolspannung anlegt, derart, daß eine Wanderung von Akzeptoren und/oder Donatoren in der entsprechenden Richtung stattfindet.

17. Halbleiter-Bauelement aus einem mit wenigstens zwei Elektroden versehenen Halbleiter, hergestellt nach dem Herstellungsverfahren nach einem der Ansprüche 12 bis 15.

18. Halbleiter-Bauelement aus einem mit wenigstens zwei Elektroden versehenen Halbleiter mit Wanderung von Donatoren und/oder Akzeptoren bei Anlegen einer Spannung gemäß dem Verfahren nach einem der Ansprüchw 1 bis 11.

19. Verwendung des Halbleiter-Bauelements nach Anspruch 17 oder 18 als spannungsabhängiger Widerstand.

20. Verwendung des Halbleiter-Bauelements gemäß Anspruch 17 oder 18 als Diode, insbesondere Gleichrichter-Diode.

21. Verwendung des Halbleiter-Elements nach Anspruch 17 oder 18 als Steuerelement (Schalter, Verstärker oder dergl.) zur Steuerung eines Betriebsstroms- bzw. -spannung mittels eines Steuerstroms- bzw. Steuerspannung.

22. Verfahren zur Anreicherung von Stoffen, welche gemäß dem Verfahren nach einem der Ansprüche 1 bis 11 in einem Festkörper bei Anlegen einer Spannung wandern, dadurch g e k e n n z e i c h n e t , daß man den Festkörper mit dem Stoff beaufschlägt und an den Festkörper die elektrische Spannung anlegt.

23. Verfahren nach Anspruch 22,

dadurch g e k e n n z e i c h n e t ,

daß man wenigstens diejenige am Festkörper vorgesehene Elektrode, zu der die Stoffe wandern, für den Stoff durchlässig ausbildet.

24. Verfahren nach Anspruch 22 oder 23,

dadurch g e k e n n z e i c h n e t ,

daß man bei anzureichernden Stoffen, welche im Bereich der jeweiligen Elektrode kondensieren, die entsprechende Seite des Festkörpers in Kontakt mit einem festen oder flüssigen Aufnahmemedium für den festen Stoff bringt.

25. Anwendung des Verfahrens nach einem der Ansprüche 22 bis 24 zur Isotopen-Trennung.

26. Anwendung des Verfahrens nach einem der Ansprüche 22 bis 24 zur Gewinnung von Einzelbestandteilen aus einem Fluid,

dadurch g e k e n n z e i c h n e t ,

daß man den Festkörper mit dem Fluid in Kontakt bringt zur selektiven Beaufschlagung des Festkörpers mit einem im Festkörper in Wanderung versetzbaren Einzelstoff, und daß man zur Gewinnung des Einzelstoffes an den Festkörper Spannung anlegt.

27. Gasspeicher, bestehend aus einem Festkörper, welcher gemäß dem Verfahren nach einem der Ansprüche 22 bis 24 mit einem gasförmigen Stoff beaufschlagbar und zur Abgabe des Gases unter elektrische Spannung setzbar ist.

# FIG.1

# FIG.2

$\Delta E = 0.58\,mV\,(\Delta\,PO_2 = 4.4 \times 10^{-6}\,atm)$

750°C
$TiO_2(+0.5\,\%\,Fe)$ -1-KRISTALL
Pt
10
CO/$CO_2$-MISCHUNG

o : Akzeptor ( O⁻⁻ )
x : Donator

TiO₂    intrinsisch

FIG.3

TiO₂    n    │    p    130
132

FIG.4

Cu₂O    p    o : O⁻⁻ Ion

FIG.5

Cu₂O    232    230
n    p

FIG.6

InSb    intrinsisch    o : Sb³⁻
x : In³⁺

FIG.7

InSb    332    330
n    p

FIG.8

Si    p    o : Akzeptor z.B. B
x : Cu⁺⁺

FIG.9

Si    432    430
n    p

FIG.10